(19) Europäisches Patentamt
European Patent Office
Office européen des brevets

(11) Veröffentlichungsnummer : **0 134 507**
**B1**

(12) **EUROPÄISCHE PATENTSCHRIFT**

(45) Veröffentlichungstag der Patentschrift : **02.12.87**

(51) Int. Cl.⁴ : **C 03 B 37/025**, C 23 C 16/44

(21) Anmeldenummer : **84108296.9**

(22) Anmeldetag : **13.07.84**

(54) **Verfahren zur Beschichtung eines Körpers.**

(30) Priorität : **20.07.83 DE 3326043**

(43) Veröffentlichungstag der Anmeldung : **20.03.85 Patentblatt 85/12**

(45) Bekanntmachung des Hinweises auf die Patenterteilung : **02.12.87 Patentblatt 87/49**

(84) Benannte Vertragsstaaten : **AT BE CH DE FR GB IT LI NL SE**

(56) Entgegenhaltungen :
**EP-A- 0 026 625**
**WO-A-82 /033 45**
**DE-A- 2 930 781**
**FR-A- 2 399 978**
**GB-A- 2 073 442**
**GB-A- 2 079 742**
**US-A- 4 002 512**

(73) Patentinhaber : **Licentia Patent-Verwaltungs-GmbH**
**Theodor-Stern-Kai 1**
**D-6000 Frankfurt/Main 70 (DE)**

(72) Erfinder : **Kühne, Reinhart, Dr. rer. nat.**
**Kelternweg 137**
**D-7900 Ulm (DE)**
Erfinder : **Kuisl, Max, Dr. rer. nat.**
**Binsenweiherweg 9**
**D-7900 Ulm (DE)**

(74) Vertreter : **Schulze, Harald Rudolf, Dipl.-Ing. et al**
**Licentia Patent-Verwaltungs-GmbH Theodor-Stern-Kai 1**
**D-6000 Frankfurt/Main 70 (DE)**

**EP 0 134 507 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein Verfahren zur Beschichtung eines Körpers.

Die Erfindung betrifft insbesondere ein Verfahren zur Beschichtung eines kreiszylinderförmigen Trägerkörpers mit $SiO_2$-Teilchen zur Herstellung einer Vorform für einen Lichtwellenleiter. Dabei werden die $SiO_2$-Teilchen unter Verwendung eines Aerosolstromes auf den Trägerkörper aufgebracht.

Ein derartiges Verfahren ist bekannt aus der US-A-4 002 512. Bei diesem Verfahren wird gasförmiges Dichlorsilan ($SiH_2Cl_2$) mit einem oxidierenden Gas, z. B. $O_2$ oder Wasserdampf ($H_2O$) umgesetzt, so daß ein strömendes Aerosol, im folgenden auch Aerosolstrom genannt, entsteht, das $SiO_2$-Teilchen enthält. Dieser $SiO_2$-haltige Aerosolstrom wird verwendet, um unterschiedliche Trägerkörper mit einer glasigen $SiO_2$-Schicht zu beschichten. Als Trägerkörper wird beispielsweise eine kreiszylinderförmiger Glasstab genannt, der entsprechend einem herzustellenden Lichtwellenleiter mit unterschiedlichen Glasschichten beschichtet wird. Anschließend wird der Glasstab entfernt, so daß ein Rohr entsteht, das kollabiert und anschließend zu einem Lichtwlellenleiter ausgezogen wird.

In einem derartigen Aerosolstrom bewegen sich die $SiO_2$-Partikel (Teilchen) nachteiligerweise unter verschiedenen Winkeln in verschiedene Richtungen. Ein derartiger Aerosolstrom ist oftmals unwirtschaftlich anwendbar, z. B. in Beschichtungsanlagen, bei denen lediglich die mit den Partikeln zu beschichtenden Gegenstände getroffen werden sollen und nicht deren Umgebung. Es ist naheliegend, einen derartigen Aerosolstrom durch mechanische Mittel, z. B. Blenden, einzugrenzen. Ein derartiges Vorgehen ist in nachteiliger Weise ebenfalls unwirtschaftlich, da die beispielsweise gewählten Blenden unerwünschterweise ebenfalls beschichtet werden. Bei dem Aerosolstrom treten Verluste auf, es werden kostenaufwendige Reinigungsarbeiten benötigt.

Aus der nicht vorveröffentlichen EP-A1-0 116 342, die unter Artikel 54 (3) EPÜ fällt, ist ein Verfahren zur Herstellung einer Vorform für Lichtwellenleiter bekannt, bei welchem durch eine flammenfreie chemische Umsetzung von dampfförmigem Siliziumtetrachlorid ($SiCl_4$) mit Wasserdampf ($H_2O$) ein $SiO_2$-haltiges Aerosol erzeugt wird.

Aus der US-A-4 062 665 ist ein sogenanntes VAD-Verfahren (« vertical axial deposition ») zur Herstellung einer Vorform für einen Lichtwellenleiter bekannt, bei welchem mit Hilfe eines Brenners durch Flammenhydrolyse ein $SiO_2$-haltiger Aerosolstrom erzeugt wird. Zur Vermeidung von $SiO_2$-haltigen Ablagerungen an dem Brenner ist in diesem eine Düsenanordnung vorhanden, die eine Führung der einzelnen Reaktionskomponenten sowie des entstandenen Aerosolstrom mit Hilfe eines Inertgases ermöglichen.

Aus der EP-A2-0 026 625 ist ein weiteres VAD-Verfahren zur Herstellung einer Vorform für einen Lichtwellenleiter bekannt. Dabei erfolgt mit Hilfe eines Brenners und der Flammenhydrolyse eine glasbildende Reaktion, bei der $SiCl_4$ mit $O_2$ umgesetzt wird. Es werden Dotierstoffe verwendet, die keine flüchtigen Chloride bilden. Die Dotierstoffe werden als flüssige Lösung in den Brenner eingebracht und dort vernebelt.

In der FR-A-2 399 978 wird ein VAD-Verfahren beschrieben, bei welchem mit Hilfe der Flammenhydrolyse und eines entsprechenden Brenners $SiO_2$-Teilchen erzeugt werden. Dabei wird zwischen dem gasförmigen $SiCl_4$ und der $O_2/H_2$-Zuführung ein Inertgas eingeleitet, um eine $SiO_2$-Abscheidung auf dem Brenner zu vermeiden.

In der GB-A-2 079 742 wird ein sogenanntes Innenbeschichtungsverfahren beschrieben zur Herstellung einer Vorform für einen Lichtwellenleiter. Dabei wird die Innenwand eines (Quarz)-Glasrohres mit den für einen Lichtwellenleiter erforderlichen dotierten und/oder undotierten Schichten beschichtet.

Zur Erhöhung der Abscheidungsrate wird in dem Rohr ein zusätzliches elektrisches Feld erzeugt.

Der Erfindung liegt daher die Aufgabe zugrunde, herkömmliche Verfahren dahingehend zu verbessern, daß ein kostengünstig beherrschbarer Aerosolstrom mit einer möglichst hohen Partikeldichte möglich wird, der insbesondere für Beschichtungs- und/oder Abscheideanlagen zur Herstellung einer Vorform für einen Lichtwellenleiter geeignet ist.

Diese Aufgabe wird erfindungsgemäß gelöst durch die im Patentanspruch 1 angegebenen Merkmale. Weiterbildungen und Ausgestaltungen sind den Unteransprüchen entnehmbar.

Die Erfindung wird im folgenden anhand eines Ausführungsbeispielsnäher erläutert unter Bezugnahme auf eine schematische Zeichnung.

Die Figur zeigt einen Längsschnitt durch einen Aerosolgenerator, der aus im wesentlichen konzentrisch angeordneten Rohren 21, 31, 41 besteht, die einen Querschnitt besitzen, der an die Verwendung des erzeugten Aerosolstromes angepaßt ist. Der Querschnitt ist beispielsweise kreis- oder rechteckförmig gewählt. Durch die inneren Rohre 21, 31 werden laminar strömende gas- und/oder dampfförmige Komponenten 2, 3 zunächst zu einem Reaktionsraum 1 geführt. Dort entsteht durch Diffusion ein Gas- und/oder Dampfgemisch, das sich durch eine chemische Reaktion zu einem Aerosol, dem Aerosolstrom 10, umsetzt. Diese chemische Reaktion wird beispielsweise durch Wärmeeinwirkung ausgelöst, die durch einen um den Reaktionsraum 10 angebrachten Ofen 60 erzeugt wird. Der entstandene im wesentlichen laminar strömende Aerosolstrom 10 wird nun durch einen aerosol-(partikel)-freien Gas- und/oder Dampfstrom 20 geführt, welcher dem Aerosolstrom 10 durch das äußere Rohr 41 zugeleitet wird. Der ebenfalls im wesentlichen laminar strömende Gas- und/oder Dampfstrom 20 verhindert eine radiale Bewegung der im Aerosolstrom 10 enthaltenen Partikel. Dadurch wird es insbesondere bei Beschichtungsanlagen möglich, den Querschnitt des Aerosolstromes 10 durch Düsen so zu formen, daß eine wirtschaftliche Beschichtung möglich wird. Durch den Gas- und/oder Dampfstrom 20 wird insbesondere eine Verkrustung der Düsen vermieden, so daß kostenungünstige Reinigungen vermieden werden. In der Figur ist ein zu beschichtender Körper 40 dargestellt, der von aerodynamischen Leitkörpern 50 so umgeben ist, daß die im Aerosolstrom 10 enthaltenen Partikeln nahezu vollständig auf den Körper 40 treffen und in dieser Weise eine wirtschaftliche Beschichtung ermöglichen. Zur weiteren Unterstützung der Abscheidungsrate ist es möglich, zwischen dem Körper 40 und den Leitkörpern 50 ein elektrisches Feld zu erzeugen, durch welches die im Aerosolstrom 10 enthaltenen Partikel auf den Körper 40 geleitet werden. Bestehen diese Partikelnaus einem Dielektrikum, z. B. Glas, so ist es möglich, das elektrische Feld derart auszubilden, daß in den Partikeln elektrische Dipole entstehen, welche die Beschichtung des Körpers 40 unterstützen. Durch derartige Dipole wird vermieden, daß sich der Körper 40 elektrostatisch derart auflädt, daß eine weitere Beschichtung erschwert wird.

Anwendungsbeispiel

Der Körper 40 wird als stab- oder rohrförmiger Trägerkörper ausgebildet, dessen äußere Mantelfläche mit einer glasigen und/oder glasbildenden Schicht derart beschichtet werden soll, daß eine sogenannte Vorform entsteht, aus der ein Lichtwellenleiter gezogen werden kann. Bei diesem Beispiel wird der Körper 40 um seine Längsachse gedreht, der Querschnitt der Rohre 21, 31, 41 ist rechteckförmig ausgebildet, so daß eine gleichzeitige Beschichtung entlang einer Mantellinie des Körpers 40 möglich wird. Die in den Rohren 21, 31 geführten Komponenten 2 bzw. 3 bestehen aus Siliziumtetrachlorid ($SiCl_4$) bzw. Wasserdampf ($H_2O$), die sich im Reaktionsraum 1 unter Wärmeeinwirkung zu einem Siliziumdioxid ($SiO_2$)-haltigen Aerosolstrom umsetzen gemäß der Formel

$$SiCl_4 + 2\ H_2O \rightarrow SiO_2 + 4\ HCl.$$

Dieser Aerosolstrom wird durch einen Gas- und/oder Dampfstrom 20 geführt, der ein inertes Gas, z. B. $N_2$, enthält. Werden dem gasförmigen Siliziumtetrachlorid Dotierstoffe, z. B. Germaniumtetrachlorid($GeCl_4$), zugesetzt, so ist es möglich, auf dem Trägerkörper dotierte Glasschichten abzuscheiden. Die Strömungsgeschwindigkeiten innerhalb der Rohre 21, 31, 41 werden so gewählt, daß einerseits eine laminare Strömung entsteht, aber andererseits eine Rückdiffusion aus dem Reaktionsraum 1 vermieden wird. Dadurch wird eine unerwünschte Partikel-Abscheidung in den Rohren 21, 31, 41 vermieden.

Die Erfindung ist nicht auf das beschriebene Ausführungsbeispiel beschränkt, sondern sinngemäß auf weitere Beispiele anwendbar, z. B. auf die Beschichtung von Silizumscheiben (Wafern).

**Patentansprüche**

1. Verfahren zur Beschichtung eines Körpers, insbesondere zur Beschichtung eines kreiszylinderförmigen Trägerkörpers mit $SiO_2$-Teilchen zur Herstellung einer Vorform für einen Lichtwellenleiter, unter Verwendung eines Aerosolstromes,
bei dem aus einem Gas- und/oder Dampfgemisch durch eine flammenfreie chemische Reaktion ein Aerosol erzeugt wird, das insbesondere $SiO_2$-Teilchen enthält zur Herstellung einer Vorform für einen Lichtwellenleiter,
bei dem einem heizbaren Reaktionsraum (1) laminar strömende dampf- und/oder gasförmige Komponenten (2, 3) zugeführt werden,
bei dem in dem Reaktionsraum (1) durch einen Diffusionsvorgang aus den Komponenten (2, 3) zunächst das Gas und/oder Dampfgemisch erzeugt wird, das anschließend durch die flammenfreie chemische Reaktion zu dem Aerosol umgesetzt wird,
bei welchem der entstehende Aerosolstrom (10) im wesentlichen laminar geführt wird durch einen im wesentlichen aerosolfreien Gas- und/oder Dampfstrom (20),
bei welchem der Aerosolstrom (10) auf einen zu beschichtenden festen Körper (40) geleitet wird,
bei welchem zur Formung des Aerosolstromes (10) im Bereich des Körpers (40) mindestens ein aerodynamischer Leitkörper (50) angebracht wird, welcher die Beschichtung des Körpers (40) unterstützt und
bei dem zur weiteren Unterstützung der Beschichtung zwischen dem Körper (40) und dem Leitkörper (50) ein dielektrisches Feld anlegbar ist.

2. Verfahren zur Beschichtung eines Körpers nach Anspruch 1, dadurch gekennzeichnet, daß als Gas- und/oder Dampfstrom (20) ein intertes Gas verwendet wird.

3. Verfahren zur Beschichtung eines Körpers nach Anspruch 1 oder Anspruch 2, dadurch gekennzeichnet, daß die Komponenten (2, 3) sowie der Gas- und/oder Dampfstrom (20) in im wesentlichen konzentrisch angeordneten Rohren (21, 31, 41) zum Reaktionsraum (1) geführt werden und daß der Gas- und/oder Dampfstrom (20) im äußersten der Rohre (41) geführt wird.

4. Verfahren zur Beschichtung eines Körpers nach einem der vorhergehenden Ansprüche, dadurch gekennzeichnet, daß mindestens eines der Rohre (41) an einem Ende als Düse ausgebildet wird, die eine Wirbelbildung des Aerosolstromes (10) vermeidet.

5. Verfahren zur Beschichtung eines Körpers nach einem der vorhergehenden Ansprüche, dadurch gekennzeichnet, daß bei einem Aerosolstrom (10) mit dielektrischen Partikeln das elektrische Feld derart ausgebildet wird, daß elektrisch

polarisierte Partikel erzeugt werden, welche die Beschichtung des Körpers (40) unterstützen.

6. Verfahren zur Beschichtung eines Körpers nach einem der vorhergehenden Ansprüche, dadurch gekennzeichnet, daß als Körper (40) mindestens ein kreiszylinderförmiger Trägerkörper verwendet wird, der im wesentlichen gleichzeitig entlang mindestens einer Mantellinie beschichtet wird derart, daß eine Vorform zur Herstellung eines Lichtwellenleiters entsteht.

7. Verfahren zur Beschichtung eines Körpers nach einem der vorhergehenden Ansprüche, dadurch gekennzeichnet, daß im Aerosolstrom (10) dotierte und/oder undotierte $SiO_2$-Partikel zur Beschichtung benutzt werden.

**Claims**

1. Method for the coating of a body, in particular for the coating of a circularly cylindrical carrier body with silicon dioxide particles for the production of a preform for an optical conductor, with the use of an aerosol current,

in which an aerosol, which in particular contains silicon dioxide particles for the production of a preform for an optical conductor, is produced from a mixture of gas and/or vapour through a flame-free chemical reaction,

in which laminarly flowing vapourous and/or gaseous components (2, 3) are conducted to a heatable reaction space (1),

in which the mixture of gas and/or vapour is produced initially from the components (2, 3) through a diffusion process in the reaction space (1) and subsequently converted into the aerosol through the flame-free chemical reaction,

in which the arising aerosol current (10) is conducted substantially laminarly through a substantially aerosol-free current (20) of gas and/or vapour,

in which the aerosol current (10) is led to a solid body (40) to be coated,

in which at least one aerodynamic guide body (50), which enhances the coating of the body (40), is mounted for the formation of the aerosol current (10) in the region of the body (40) and

for which a dielectric field is appliable between the body (40) and the guide body (50) for further enhancement of the coating.

2. Method for the coating of a body according to claim 1, characterised thereby, that an inert gas is used as current (20) of gas and/or vapour.

3. Method for the coating of a body according to claim 1 or claim 2, characterised thereby, that the components (2, 3) as well as the current (20) of gas and/or vapour are conducted in substantially concentrically arranged tubes (21, 31, 41) to the reaction space (1) and that the current (20) of gas and/or vapour is conducted in the outermost of the tubes (41).

4. Method for the coating of a body according to one of the preceding claims, characterised thereby, that at least one of the tubes (41) is constructed at one end as a nozzle which avoids a turbulent formation of the aerosol current (10).

5. Method for the coating of a body according to one of the preceding claims, characterised thereby, that the electric field in the case of an aerosol current (10) with dielectric particles is formed in such a manner that electrically polarised particles are produced, which enhance the coating of the body (40).

6. Method for the coating of a body according to one of the preceding claims, characterised thereby, that at least one circularly cylindrical carrier body is used as body (40) and coated substantially simultaneously along at least one cylindrical generatrix in such a manner that a preform for the production of an optical conductor arises.

7. Method for the coating of a body according to one of the preceding claims, characterised thereby, that doped and/or undoped silicon dioxide particles are utilised for coating in the aerosol current (10).

**Revendications**

1. Procédé de dépôt d'une couche sur un corps, en particulier dépôt d'une couche sur un support en forme de cylindre circulaire avec des particules de $SiO_2$ pour fabriquer une préforme pour un guide d'ondes lumineuses, en employant un courant d'aérosol,

dans lequel, à partir d'un mélange de gaz et/ou de vapeur, on produit, par une réaction chimique sans flamme, un aérosol qui contient en particulier des particules de $SiO_2$ pour fabriquer une préforme pour un guide d'ondes lumineuses,

dans lequel on amène dans une chambre de réaction (1) que l'on peut chauffer des composants (2, 3), sous forme de vapeur et/ou de gaz, en écoulement laminaire,

dans lequel on produit d'abord dans la chambre de réaction (1), par un processus de diffusion à partir des composants (2, 3), le mélange de gaz et/ou de vapeur que la réaction chimique sans flamme, transforme ensuite en l'aérosol,

dans lequel le courant d'aérosol (10) qui apparaît est amené à un écoulement essentiellement laminaire au moyen d'un courant de gaz et/ou de vapeur ne contenant essentiellement pas d'aérosol,

dans lequel le courant d'aérosol (10) est guidé sur un corps solide (40) sur lequel il faut déposer une couche,

dans lequel, pour donner sa forme au courant d'aérosol (10), est rapporté, au voisinage du corps (40), au moins un guide aérodynamique qui facilite le dépôt de la couche sur le corps (40) et

dans lequel, pour continuer à faciliter le dépôt de la couche, on peut créer un champ diélectrique entre le corps (40) et le guide (50).

2. Procédé de dépôt d'une couche sur un corps selon la revendication 1, caractérisé en ce que, comme courant de gas et/ou de vapeur (20), on emploie un gaz inerte.

3. Procédé de dépôt d'une couche sur un

corps selon la revendication 1 ou la revendication 2, caractérisé en ce que les composants (2, 3) ainsi que le courant de gaz et/ou de vapeur (20) sont amenés à la chambre de réaction (1) dans des tubes (21, 31, 41) disposés essentiellement concentriquement ; et en ce que le courant de gaz et/ou de vapeur (20) passe dans celui des tubes qui est le plus extérieur.

4. Procédé de dépôt, d'une couche sur un corps selon l'une des revendications précédentes, caractérisé en ce qu'au moins l'un des tubes (41) a, à une extrémité, la forme d'une buse qui évite la formation d'une turbulence du courant d'aérosol (10).

5. Procédé de dépôt, d'une couche sur un corps selon l'une des revendications précédentes, caractérisé en ce que, dans le cas d'un courant d'aérosol (10) avec particules diélectriques, le champ électrique est conçu de façon telle que l'on produit des particules polarisées électriquement qui facilitent le dépôt de la couche sur le corps (40).

6. Procédé de dépôt d'une couche sur un corps selon l'une des revendications précédentes, caractérisé en ce que comme corps (40) on emploie au moins un support en forme de cylindre circulaire qui est revêtu essentiellement simultanément le long d'au moins une génératrice de façon telle qu'il apparaît une préforme pour la fabrication d'un guide d'ondes lumineuses.

7. Procédé de dépôt d'une couche sur un corps selon l'une des revendications précédentes, caractérisé en ce que dans le courant d'un aérosol (10) on utilise, pour le dépôt de la couche, des particules de $SiO_2$ dopées et/ou non dopées.

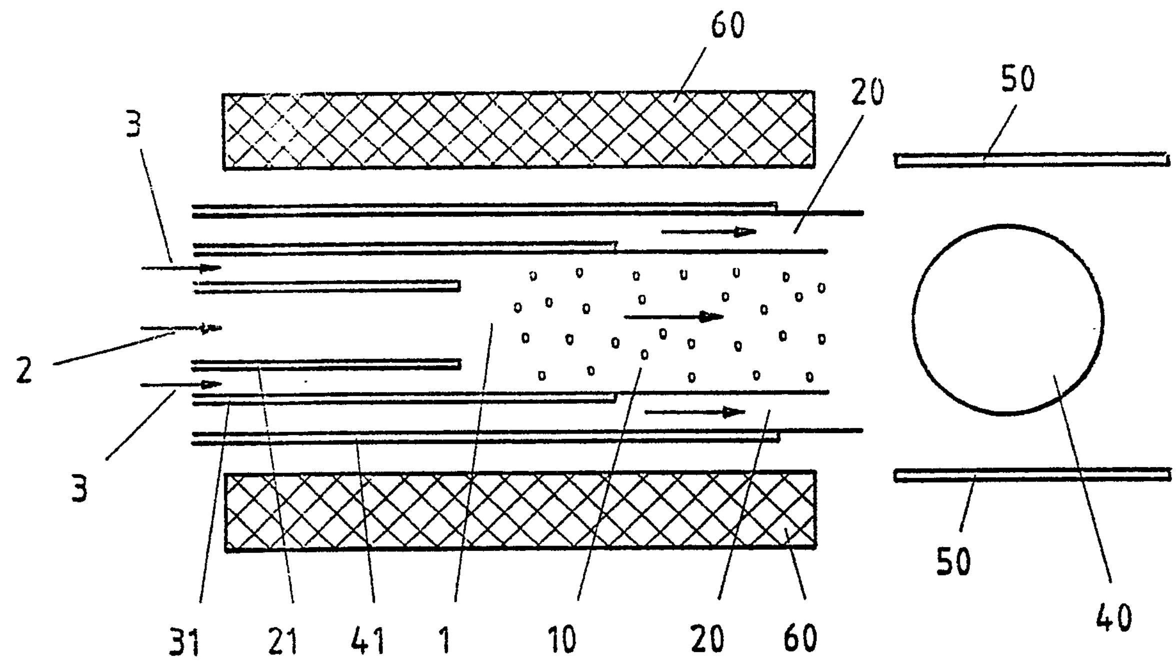
60
20
50
3
2
3
50
40
31
21
41
1
10
20
60